# EUROPEAN PATENT APPLICATION

(11) **EP 4 836 601 A1**
(43) Date of publication of application: **04.11.2026**
(21) Application number: 26164975.0
(22) Date of filing: 16.03.2026
(51) Int. Cl.: H05K 3/46, H05K 1/11, H05K 3/40

(54) **LAMINATED SUBSTRATE AND METHOD FOR MANUFACTURING LAMINATED SUBSTRATE**

(30) Priority: 22.04.2025 JP 2025070395
(71) Applicant: FICT LIMITED, Nagano-shi, Nagano 381-8501 (JP)
(72) Inventor: OZAKI, Norikazu, Nagano-shi, Nagano, 381-8501 (JP); MIYAGAWA, Tetsurou, Nagano-shi, Nagano, 381-8501 (JP); NAKAGAWA, Takashi, Nagano-shi, Nagano, 381-8501 (JP); SAKAI, Naoki, Nagano-shi, Nagano, 381-8501 (JP)
(74) Representative: Hoffmann Eitle

(57) **Abstract**

A laminated substrate (100) includes a plurality of multilayer substrates (10) that are stacked. In each multilayer substrate (10), a through-hole (30) that extends through the multilayer substrate (10), has a plated inner wall surface, and is filled with resin (32), and bonding lands (34) that are electrically connected to the through-hole (30) on upper and lower surfaces of the through-hole (30) are formed. An insulating adhesive layer (40) and conductive paste vias (50) that electrically connect the bonding lands (34) of the opposed multilayer substrates (10) to each other through conductive paste filling a through-hole (46) formed in the insulating adhesive layer (40) are provided between each multilayer substrate (10). The conductive paste vias (50) are provided at positions different from the through-hole (30) and at three locations around the through-hole (30).

## Description

### Technical Field

The present invention relates to a laminated substrate and a method for manufacturing a laminated substrate.

### Background Art

Conventionally, circuit boards such as printed wiring boards have been widely used to compactly incorporate electronic components into electronic devices. Meanwhile, with the demand for smaller sizes, higher performance, and lower prices for electronic devices, miniaturization and multilayering of electronic circuits on circuit boards and high-density mounting of electronic components have rapidly advanced, and studies on multilayer substrates, in which printed circuit boards have a multilayer structure, have become active.

When forming through-holes in a multilayer substrate, the drill diameter for forming through-holes needs to be increased as the number of layers and the plate thickness increase. This prevents adaptation to fine pitch formation. As such, it has been contemplated to prepare a multilayer substrate in which through-holes are formed with as small a drill diameter as possible in a state in which the number of layers is relatively small, and then stack multiple such multilayer substrates to obtain a final multilayer laminated substrate.

For example, PTL 1 (JP-A-2011-258779) discloses a laminated substrate in which an adhesive layer is stacked on the upper surface of one multilayer substrate, a through-hole is formed in this adhesive layer, this through-hole is filled with conductive paste, and another multilayer substrate is stacked above the adhesive layer and the conductive paste.

Also, interlayer coupling of the multilayer substrates is achieved by through-holes having plated inner walls, and bonding lands formed by metal layers are formed on the upper and lower surfaces of the through-holes. The above-mentioned conductive paste electrically connects these bonding lands to each other.

### Summary of Invention

### Technical Problem

PTL 1 described above discloses a configuration in which bonding lands of through-holes that extend through multilayer substrates to provide interlayer coupling are electrically connected to each other by conductive paste.

However, the through-hole formed in each multilayer substrate is filled with resin to bond the layers forming the multilayer substrate together. As such, when the conductive paste is placed directly above the through-hole, thermal expansion of the resin caused when the multilayer substrates are bonded to each other through thermocompression bonding applies stress to the conductive paste, resulting in a problem in that the long-term reliability of the conductive paste may be hindered.

In this respect, to solve the above problem, it is an object of the present invention to provide a laminated substrate and a method for manufacturing a laminated substrate that can ensure long-term reliability by preventing stress from being applied to conductive paste that is to electrically connect a plurality of multilayer substrates to each other when manufacturing a laminated substrate by stacking the multilayer substrates.

### Solution to Problem

A laminated substrate according to the present invention is a laminated substrate including a plurality of multilayer substrates that are stacked, in which in each multilayer substrate, a through-hole that extends through the multilayer substrate, has a plated inner wall surface, and is filled with resin, and bonding lands that are electrically connected to the through-hole on upper and lower surfaces of the through-hole are formed, an insulating adhesive layer and conductive paste vias that electrically connect the bonding lands of the opposed multilayer substrates to each other through conductive paste filling a through-hole formed in the insulating adhesive layer are provided between each multilayer substrate, the conductive paste vias are provided at positions different from a position at which the through-hole of the multilayer substrate is formed, the bonding land is formed to have a size that allows the through-hole of the multilayer substrate and the plurality of conductive paste vias to be placed, and the bonding land has a shape in which a first circular portion centered on the through-hole of the multilayer substrate is coupled to three second circular portions that are located around the first circular portion and centered on the conductive paste such that the conductive paste vias are provided at three locations around the through-hole of the multilayer substrate as a center.

By adopting this configuration, even if the resin in the through-hole thermally expands, the conductive paste vias are located at three locations around the through-hole, so that long-term reliability can be maintained without being subjected to stress caused by the effects of thermal expansion. Furthermore, by providing three conductive paste vias for one through-hole, even in a case in which a relatively large current flows, such as a through-hole for a power supply, providing three conductive paste vias can reduce the resistance value and limit an increase in the heat generation amount. By limiting an increase in the heat generation amount, the risk of fusing can be eliminated.

The second circular portions may be placed around the first circular portion at intervals of 120 degrees from each other.

A laminated substrate according to the present invention is a laminated substrate including a plurality of multilayer substrates that are stacked, in which in each multilayer substrate, a through-hole that extends through the multilayer substrate, has a plated inner wall surface, and is filled with resin, and bonding lands that are electrically connected to the through-hole on upper and lower surfaces of the through-hole are formed, an insulating adhesive layer and conductive paste vias that electrically connect the bonding lands of the opposed multilayer substrates to each other through conductive paste filling a through-hole formed in the insulating adhesive layer are provided between each multilayer substrate, the conductive paste vias are provided at positions different from a position at which the through-hole of the multilayer substrate is formed, the bonding land is formed to have a size that allows the through-hole of the multilayer substrate and the plurality of conductive paste vias to be placed, and the bonding land has an oval shape such that the conductive paste vias are provided at two locations that are point symmetric with respect to the through-hole of the multilayer substrate.

By adopting this configuration, even if the resin in the through-hole thermally expands, the conductive paste vias are located at two locations around the through-hole, so that long-term reliability can be maintained without being subjected to stress caused by the effects of thermal expansion. Furthermore, by providing two conductive paste vias for one through-hole, even in a case in which a relatively large current flows, such as a through-hole for a power supply, providing two conductive paste vias can reduce the resistance value and limit an increase in the heat generation amount. Additionally, the oval-shaped bonding land can reduce the area of the bonding land, so that noise can be reduced even with through-holes that require noise countermeasures, such as signal lines.

A method for manufacturing a laminated substrate according to the present invention is a method for manufacturing a laminated substrate by stacking a plurality of multilayer substrates in which a through-hole that has a plated inner wall surface and is filled with resin, and bonding lands that are electrically connected to the through-hole on upper and lower surfaces of the through-hole are formed, the method including the steps of: stacking an insulating adhesive layer on an upper surface of one multilayer substrate; forming through-holes that extend through the insulating adhesive layer at positions different from a position of the through hole of the multilayer substrate and at a plurality of locations around the through-hole of the multilayer substrate such that the respective bonding lands of one multilayer substrate and another multilayer substrate opposed to the one multilayer substrate are electrically connected to each other; filling the through-holes of the insulating adhesive layer with conductive paste to form conductive paste vias; and thermocompression-bonding the plurality of multilayer substrates to harden the insulating adhesive layer and the conductive paste and integrate the plurality of multilayer substrates, in which before the step of stacking the insulating adhesive layer on the upper surface of the one multilayer substrate, the method includes the step of filling a recess between the bonding land and another metal layer or another bonding land with insulating resin on an upper surface of the one multilayer substrate and a lower surface of the other multilayer substrate and polishing a surface to flatten a surface opposed to the other multilayer substrate so that there are no irregularities.

According to this method, even if the resin in the through-hole thermally expands, the conductive paste vias are provided at multiple locations around the through-hole, so that a laminated substrate can be obtained that can maintain long-term reliability without being subjected to stress caused by the effects of thermal expansion of the through-hole. Additionally, the flatness of the laminated substrate can be maintained, and an electrical connection layer formed by the conductive paste vias can be made uniform over the entire substrate, thereby preventing the occurrence of abnormal resistance values.

### Advantageous Effects of Invention

According to the present invention, it is possible to ensure long-term reliability by preventing stress from being applied to conductive paste that is to electrically connect a plurality of multilayer substrates to each other when manufacturing a laminated substrate by stacking the multilayer substrates.

### Brief Description of the Drawings

Fig. 1 is a schematic cross-sectional view showing an example of a laminated substrate;
Fig. 2 is a schematic plan view of a bonding land showing an example in which three conductive paste vias are placed for one through-hole;
Fig. 3 is a schematic plan view showing an example in which a plurality of bonding lands shown in Fig. 2 are placed;
Fig. 4 is a schematic plan view of the bonding land showing an example in which two conductive paste vias are placed for the one through-hole;
Fig. 5 is a schematic plan view showing an example in which the plurality of bonding lands shown in Fig. 4 are placed;
Fig. 6 is a schematic cross-sectional view showing an example of a method for manufacturing a multilayer substrate of a present embodiment (part 1);
Fig. 7 is a schematic cross-sectional view showing an example of the method for manufacturing a multilayer substrate of the present embodiment (part 2);
Fig. 8 is a schematic cross-sectional view showing an example of the method for manufacturing a multilayer substrate of the present embodiment (part 3);
Fig. 9 is a schematic cross-sectional view showing an example of the method for manufacturing a multilayer substrate of the present embodiment (part 4); and
Fig. 10 is a schematic cross-sectional view showing an example of the method for manufacturing a multilayer substrate of the present embodiment (part 5).

### Description of Embodiments

### (Laminated Substrate)

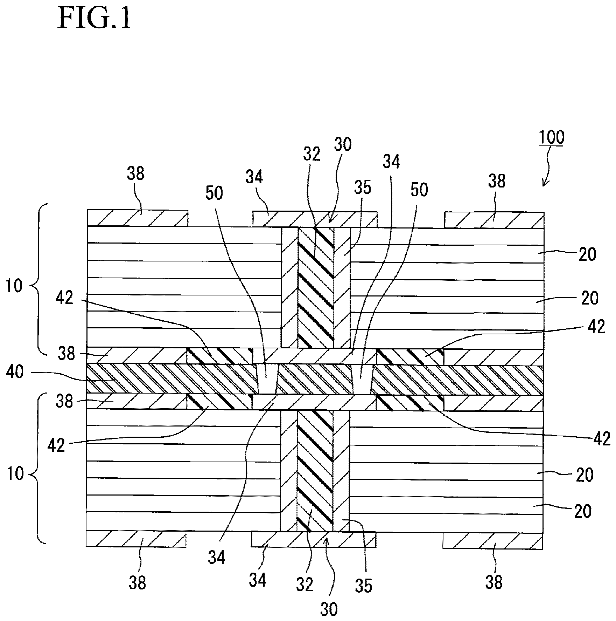

Hereinafter, an embodiment of the present invention is described with reference to the drawings. Fig. 1 shows a schematic cross-sectional view of a laminated substrate.

In this embodiment, for convenience, the terms "upper surface" and "lower surface" may be used based on the up-down direction in the drawings, but the upper surface and the lower surface of a laminated substrate 100 or a multilayer substrate 10 may not agree with their actual up and down orientations. Also, in the laminated substrate 100 or the multilayer substrate 10, the term "side surface" may be used, and the side surface means the side surface with respect to the "upper surface" and "lower surface" described above.

The laminated substrate 100 shown in Fig. 1 has, in one example, a laminated configuration in which two multilayer substrates 10 are stacked in the up-down direction and electrically connected to each other, but is not limited to stacking the two multilayer substrates 10 and can be applied to stacking two or more multilayer substrates 10.

Also, the laminated substrate 100 shown in Fig. 1 is described as an example in which both are multilayer printed wiring boards (MLBs).

Each multilayer substrate 10 includes insulating layers 20, which are made of a plurality of insulating base materials, and a metal layer (not shown) formed on the upper or lower surface of each insulating layer 20, and has a through-hole 30 formed therethrough in the up-down direction.

The insulating layer 20 is not particularly limited as long as it is an insulating layer used in a multilayer substrate, and can be selected appropriately depending on the purpose. In one example, a base material whose hardness is reinforced by an inorganic base material such as an inorganic woven fabric or an inorganic nonwoven fabric using glass cloth or the like, or by an organic base material such as an organic woven fabric or an organic nonwoven fabric may be used.

More specifically, the insulating layer 20 may use, as one example, a glass epoxy base material (a glass woven-fabric base material impregnated with an epoxy resin, or a glass nonwoven-fabric base material impregnated with an epoxy resin), a glass woven-fabric base material impregnated with a bismaleimide triazine resin, an aramid nonwoven-fabric base material impregnated with an epoxy resin, or a glass woven-fabric base material impregnated with a modified polyphenylene ether resin.

The through-hole 30 has an inner wall plated with a metal such as copper to form a plating layer 35, and a hollow portion on the inner side of the plating layer 35 is filled with resin 32. The filling of the resin 32 is to bond the layers forming the multilayer substrate so that the layers do not separate.

On the upper and lower surfaces of each multilayer substrate 10, bonding lands 34 are formed for electrical connection with through-holes 30 of other multilayer substrates 10 and semiconductor elements (not shown) or the like. A bonding land 34 is electrically connected to the plating layer 35 of the through-hole 30 and can be made of a metal such as copper.

An insulating adhesive layer 40 is interposed between the multilayer substrates 10. As the insulating adhesive layer 40, a thermosetting resin may be used, and a glass epoxy prepreg may be used in one example.

The bonding land 34 on the upper surface of the lower multilayer substrate 10 and the bonding land 34 on the lower surface of the upper multilayer substrate 10 in Fig. 1 are electrically connected by a via. This via is a conductive paste via 50 made of conductive paste. As the conductive paste, paste containing a conductive filler and a binder resin may be used.

The conductive paste vias 50 are provided at positions different from the through-holes 30, that is, at positions offset from directly above and directly below the through-holes 30. In other words, the through-holes 30 of the two multilayer substrates 10 are positioned along a straight line in the up-down direction, and the conductive paste vias 50 are provided at positions offset from this straight line.

That is, if the conductive paste vias 50 are located directly above or directly below the through-holes 30, thermal expansion of the resin 32 in the through-holes 30, which may be caused in thermocompression bonding when bonding the multilayer substrates 10 together, would apply stress to the conductive paste vias 50. This may hinder the long-term reliability of the conductive paste vias 50.

As such, by providing the conductive paste vias 50 at positions offset from directly above and directly below the through-holes 30, the conductive paste vias 50 are not subjected to stress due to thermal expansion of the resin 32 in the through-holes 30, thereby ensuring long-term reliability.

Furthermore, the placement position of the conductive paste via 50 needs to be at a distance away from the resin 32 so as to avoid the effect of thermal expansion of the resin 32 in the through-hole 30, and is set appropriately based on the type of the resin 32 and the diameter of the through-hole 30.

Also, between the bonding land 34 on the upper surface of the lower multilayer substrate 10 and an adjacent metal layer 38 (or the bonding land 34 at an adjacent position), and between the bonding land 34 on the lower surface of the upper multilayer substrate 10 and the adjacent metal layer 38 (or the bonding land 34 at an adjacent position), insulating resin 42 for flattening the surfaces of the multilayer substrates 10 is placed.

That is, since the multilayer substrates 10 have metal layers 38 including the bonding lands 34 and protruding from the surface of the insulating layers 20 at their upper and lower surfaces, the insulating resin 42 is placed to fill the step, and the surfaces of the upper surface of the multilayer substrate 10 located on the lower side and the lower surface of the multilayer substrate 10 located on the upper side can be flattened.

Also, when the step formed by the metal layer 38 including the bonding land 34 and protruding from the surface of the insulating layer 20 has a predetermined thickness or less (for example, 18 µm or less), the step does not need to be filled with the insulating resin 42. In this case, it is possible to fill this step with the insulating adhesive layer 40 when the insulating adhesive layer 40 is formed on the multilayer substrate 10 located on the lower side.

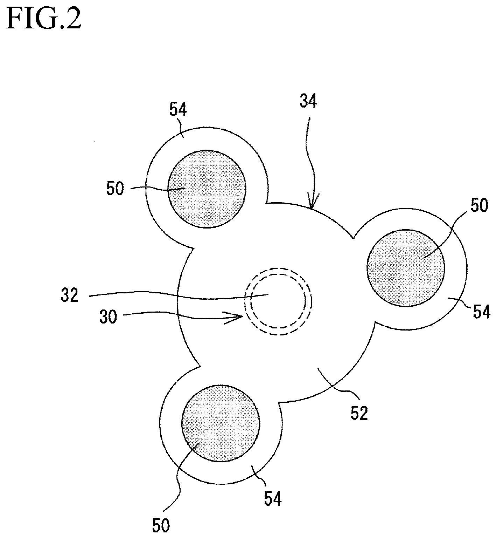

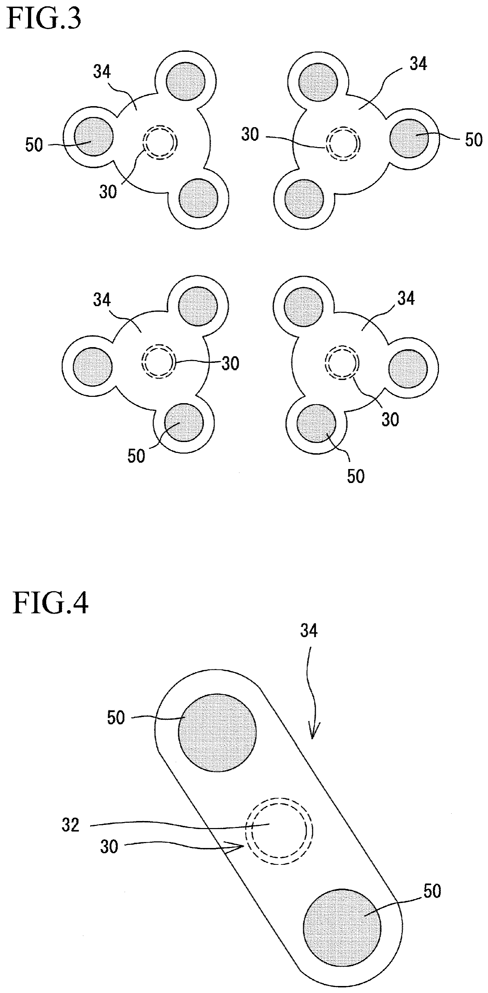

Figs. 2 and 3 are schematic plan views of bonding land portions.

The example shown in Fig. 2 uses the bonding land 34 that is sized such that three conductive paste vias 50 are placed for the bonding land 34 of one through-hole 30. The conductive paste vias 50 are provided at three locations around the through-hole 30 as a center.

The specific planar shape of the bonding land 34 is a shape in which a first circular portion 52 centered on the through-hole 30 is coupled to three second circular portions 54, which are placed around the first circular portion 52 and centered on the conductive paste vias 50. In Fig. 2, the through-hole 30 is indicated by broken lines.

Also, the three conductive paste vias 50 are placed at intervals of 120° from each other with the through-hole 30 at the center, and are placed at equal intervals with the through-hole 30 at the center. That is, the second circular portions 54 are also formed around the first circular portion 52 at intervals of 120° from each other.

In the bonding land 34 shown in Fig. 2 as an example, when the diameter of the through-hole 30 is 150 µm and the diameter of the conductive paste via 50 is 180 µm, the diameter of the first circular portion may be 400 µm, and the diameter of the second circular portion may be 300 µm. At this time, the interval between the conductive paste vias 50 is 389.7 µm.

Fig. 3 is a plan view showing an example of arrangement when a plurality of bonding lands 34 shown in Fig. 2 are formed.

Fig. 3 shows an example of arrangement in which four bonding lands 34 shown in Fig. 2 are formed, and the through-holes 30 are placed at intervals of 900 µm from each other. At this time, in each bonding land 34, one conductive paste via 50 is arranged to be mutually oriented in the central direction.

As shown in Figs. 2 and 3, as one example of a case in which a plurality of conductive paste vias 50 are placed for the bonding land 34 of the one through-hole 30, a case can be contemplated in which a relatively large current flows, such as for the through-hole 30 for a power supply. By providing a plurality of conductive paste vias 50 for the through-hole 30 through which a large current flows, the resistance value is reduced, thereby limiting an increase in the heat generation amount. In this manner, by limiting an increase in the heat generation amount, the risk of fusing at the stacking locations of the multilayer substrates 10 can be eliminated.

The example shown in Fig. 4 uses the bonding land 34 that is sized such that two conductive paste vias 50 can be placed for the bonding land 34 of the one through-hole 30. The conductive paste vias 50 are provided at two locations that are point symmetric with respect to the through-hole 30. That is, in the example of Fig. 4, the through-hole 30 and the two conductive paste vias 50 are placed so as to be aligned in a straight line.

The bonding land 34 shown in Fig. 4 has an oval shape. The oval shape as used herein refers to a shape in which both longitudinal ends of a rectangular shape are formed into semicircular shapes.

In the bonding land 34 shown in Fig. 4 as an example, when the diameter of the through-hole 30 is 150 µm and the diameter of the conductive paste via 50 is 180 µm, the length in the longitudinal direction of the oval shape may be 740 µm, and the length in the width direction of the oval shape may be 300 µm. At this time, the distance between the conductive paste vias 50 is 440 µm.

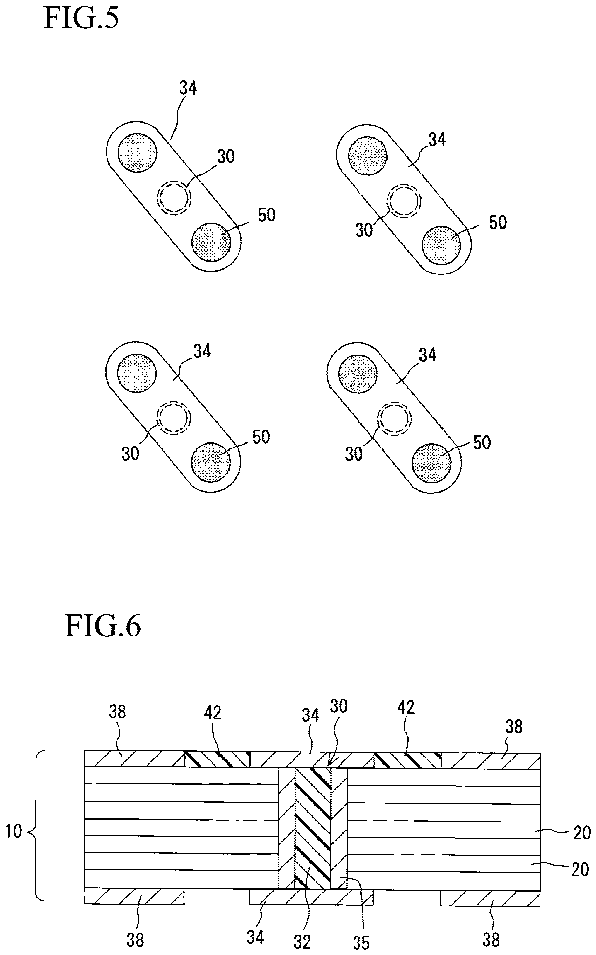

Fig. 5 is a plan view showing an example of arrangement when the plurality of bonding lands 34 shown in Fig. 4 are formed.

Fig. 5 shows an example of arrangement in which the four bonding lands 34 shown in Fig. 4 are formed, and the through-holes 30 are placed at intervals of 800 µm from each other. At this time, the longitudinal directions of the oval shapes of the bonding lands 34 are parallel to each other, and the bonding lands 34 are placed in a lattice pattern.

As shown in Figs. 4 and 5, when the two conductive paste vias 50 are placed for the bonding land 34 of the one through-hole 30, by providing the two conductive paste vias 50 for the through-hole 30 through which a large current flows, the resistance value is reduced, thereby limiting an increase in the heat generation amount. In this manner, by limiting an increase in the heat generation amount, the risk of fusing at the stacking locations of the multilayer substrates 10 can be eliminated. Furthermore, by forming the bonding land 34 to have an oval shape, the area of the bonding land can be reduced even when the plurality of conductive paste vias 50 are provided, so that the effect of noise can be reduced even with through-holes that require noise countermeasures, such as signal lines.

### (Method for Manufacturing Laminated Substrate)

Referring to Fig. 6, a method for manufacturing the laminated substrate is now described. The multilayer substrate 10 in Fig. 6 is the same as that shown in Fig. 1, the same reference numerals as in Fig. 1 are used to designate the structure, and a description thereof will be omitted.

First, when stacking the multilayer substrates 10 together, to flatten the surface opposed to another multilayer substrate 10 to be stacked, a recess between the bonding land 34 and the metal layer 38 (or another adjacent bonding land 34) is filled with the insulating resin 42. Then, the insulating resin 42 is polished to flatten the surface opposed to the other multilayer substrate 10 so that there are no irregularities. This maintains the flatness of the laminated substrate 100 and makes the electrical connection layer formed by the conductive paste vias 50 uniform over the entire substrate, thereby preventing the occurrence of abnormal resistance values.

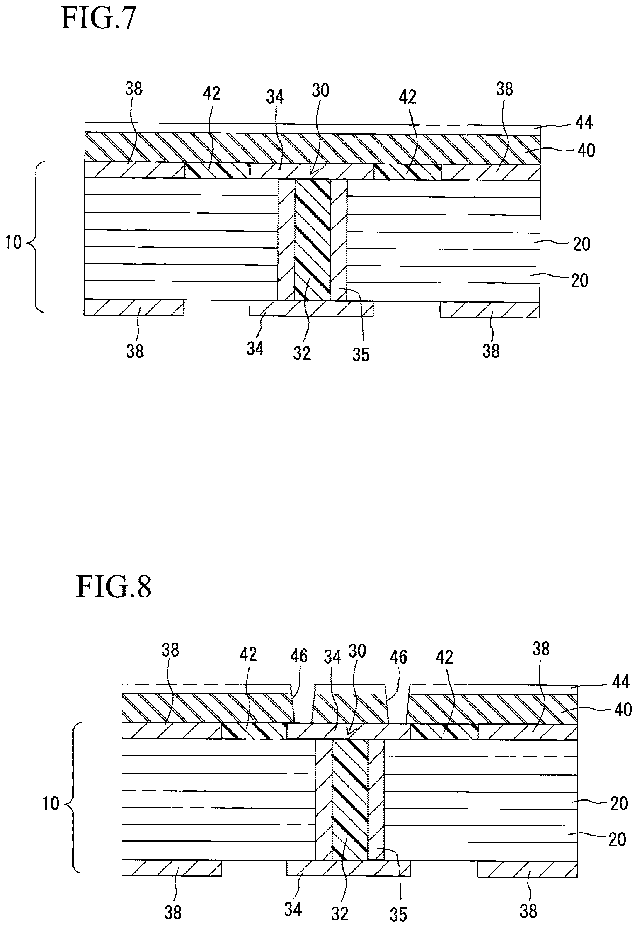

Then, as shown in Fig. 7, the insulating adhesive layer 40 is stacked on the surface opposed to another multilayer substrate 10 to be stacked. As the insulating adhesive layer 40, a thermosetting resin may be used, and a glass epoxy prepreg may be used in one example as described above. Also, when the step formed by the metal layer 38 including the bonding land 34 and protruding from the surface of the insulating layer 20 has a predetermined thickness or less (for example, 18 µm or less), the step does not need to be filled with the insulating resin 42. In this case, it is possible to fill this step with the insulating adhesive layer 40 when the insulating adhesive layer 40 is formed on the multilayer substrate 10 located on the lower side.

Additionally, a resin film 44, which protects the surface of the insulating adhesive layer 40, is stacked on the upper surface of the insulating adhesive layer 40.

The insulating adhesive layer 40 and the resin film 44 may be integrated to be sheet-shaped in advance.

Then, as shown in Fig. 8, through-holes 46 are formed in the insulating adhesive layer 40 and the resin film 44.

Each through-hole 46 is a through-hole 46 that has a bottom, extends through the insulating adhesive layer 40 and the resin film 44, and has the bonding land 34 at its bottom. In one example, the through-hole 46 can be formed by laser processing. The types of laser processing include CO2 laser, YAG laser, and the like, but they are not limited to these and can be selected appropriately depending on the purpose.

As shown in Fig. 1, since the plurality of conductive paste vias 50 are placed for the bonding land 34 of the one through-hole 30, a plurality of through-holes 46 are formed at positions different from the position at which the through-hole 30 is formed, and at positions offset from directly above the through-hole 30. In the example shown in Figs. 2 and 3, the through-holes 46 are formed at three locations around the through-hole 30, and in the example shown in Figs. 4 and 5, the through-holes 46 are formed at two locations that are point symmetric with respect to the through-hole 30.

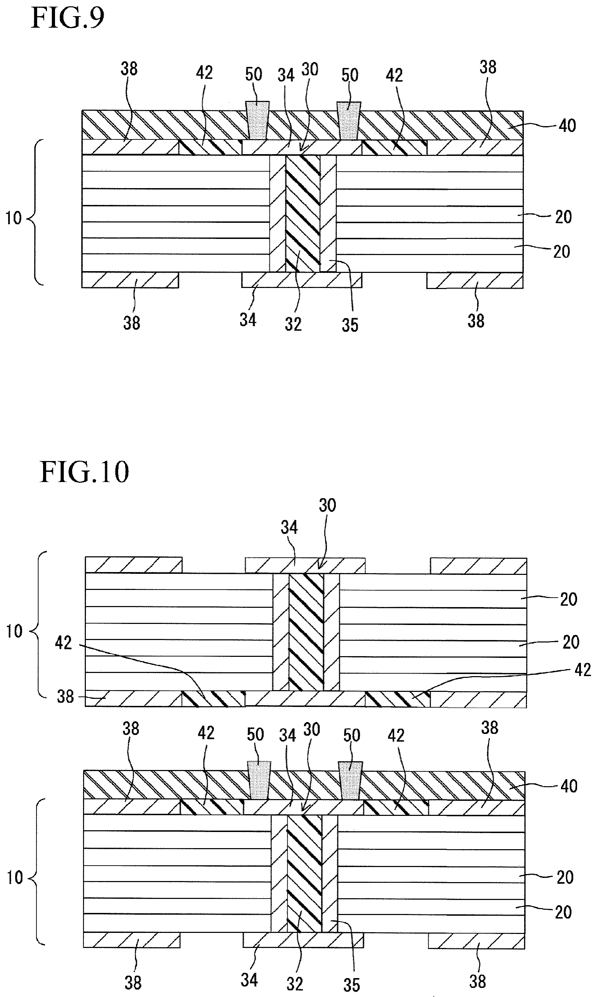

Then, as shown in Fig. 9, the through-holes 46 are filled with conductive paste, and then the resin film 44 is peeled off.

As a result, the conductive paste vias 50 are formed, and by peeling off the resin film 44, the conductive paste protrudes above the insulating adhesive layer 40 by the thickness of the resin film 44. Since the conductive paste protrudes from the insulating adhesive layer 40, the conductive paste can be reliably bonded to the bonding land 34 of another multilayer substrate 10.

Then, as shown in Fig. 10, another multilayer substrate 10 is stacked on the multilayer substrate 10 on which the insulating adhesive layer 40 and the conductive paste vias 50 are formed. Here, the lower surface of the other multilayer substrate 10 is flattened to eliminate any irregularities by filling the recess between the bonding land 34 and the metal layer 38 (or another adjacent bonding land 34) with the insulating resin 42.

Then, the multilayer substrates 10 are bonded together by thermocompression. By thermocompression bonding, the insulating adhesive layer 40 and the conductive paste vias 50 are hardened, and the laminated substrate 100 is formed in which the plurality of multilayer substrates 10 are stacked.

### (Other Embodiments of Laminated Substrate)

As for the specific types of the multilayer substrates 10 and the substrates of the multilayer substrates 10 that form the laminated substrate 100, as shown in Fig. 1, both may be multilayer printed wiring boards (MLBs), or the lower multilayer substrate 10 may be a multilayer printed wiring board (MLB), and the upper multilayer substrate 10 may be a semiconductor package substrate (PKG). Alternatively, the lower multilayer substrate 10 may be a multilayer printed wiring board (MLB), and the upper multilayer substrate 10 may be a coreless semiconductor package substrate (CL). Alternatively, a configuration may be adopted in which the multilayer substrate 10 that is a coreless semiconductor package substrate (CL) is stacked on both the upper and lower surfaces of the lower multilayer substrate 10 that is a multilayer printed wiring board (MLB).

The laminated substrate 100 of the present embodiment can be used as motherboards (supporting substrate) and can be used as interposers (interposer substrate) In particular, they can be used as motherboards and interposers of server systems and high-speed communication systems, and can also be used as circuit boards forming semiconductor elements. They are also applicable to an inspection apparatus, a probe card, and the like used to determine the quality of semiconductors.

## Claims

1. A laminated substrate (100) including a plurality of multilayer substrates (10) that are stacked, wherein
in each multilayer substrate (10), a through-hole (30) that extends through the multilayer substrate (10), has a plated inner wall surface, and is filled with resin (32), and bonding lands (34) that are electrically connected to the through-hole (30) on upper and lower surfaces of the through-hole (30) are formed,
an insulating adhesive layer (40) and
conductive paste vias (50) that electrically connect the bonding lands (34) of the opposed multilayer substrates (10) to each other through conductive paste filling a through-hole (46) formed in the insulating adhesive layer (40) are provided between each multilayer substrate (10),
the conductive paste vias (50) are provided at positions different from a position at which the through-hole (30) of the multilayer substrate (10) is formed,
the bonding land (34) is formed to have a size that allows the through-hole (30) of the multilayer substrate (10) and the plurality of conductive paste vias (50) to be placed, and
the bonding land (34) has a shape in which a first circular portion (52) centered on the through-hole (30) of the multilayer substrate (10) is coupled to three second circular portions (54) that are located around the first circular portion (52) and centered on the conductive paste such that the conductive paste vias (50) are provided at three locations around the through-hole (30) of the multilayer substrate (10) as a center.

2. The laminated substrate (100) according to claim 1, wherein the second circular portions (54) are placed around the first circular portion (52) at intervals of 120 degrees from each other.

3. A laminated substrate (100) including a plurality of multilayer substrates (10) that are stacked, wherein
in each multilayer substrate (10), a through-hole (30) that extends through the multilayer substrate (10), has a plated inner wall surface, and is filled with resin (32), and bonding lands (34) that are electrically connected to the through-hole (30) on upper and lower surfaces of the through-hole (30) are formed,
an insulating adhesive layer (40) and
conductive paste vias (50) that electrically connect the bonding lands (34) of the opposed multilayer substrates (10) to each other through conductive paste filling a through-hole (46) formed in the insulating adhesive layer (40) are provided between each multilayer substrate (10),
the conductive paste vias (50) are provided at positions different from a position at which the through-hole (30) of the multilayer substrate (10) is formed,
the bonding land (34) is formed to have a size that allows the through-hole (30) of the multilayer substrate (10) and the plurality of conductive paste vias (50) to be placed, and
the bonding land (34) has an oval shape such that the conductive paste vias (50) are provided at two locations that are point symmetric with respect to the through-hole (30) of the multilayer substrate (10).

4. A method for manufacturing a laminated substrate (100) by stacking a plurality of multilayer substrates (10) in which a through-hole (30) that has a plated inner wall surface and is filled with resin (32), and bonding lands (34) that are electrically connected to the through-hole (30) on upper and lower surfaces of the through-hole (30) are formed, the method comprising the steps of:
stacking an insulating adhesive layer (40) on an upper surface of one multilayer substrate (10);
forming through-holes (46) that extend through the insulating adhesive layer (40) at positions different from a position of the through-hole (30) of the multilayer substrate (10) and at a plurality of locations around the through-hole (30) of the multilayer substrate (10) such that the respective bonding lands (34) of one multilayer substrate (10) and another multilayer substrate (10) opposed to the one multilayer substrate (10) are electrically connected to each other;
filling the through-holes (46) of the insulating adhesive layer (40) with conductive paste to form conductive paste vias (50); and
thermocompression-bonding the plurality of multilayer substrates (10) to harden the insulating adhesive layer (40) and the conductive paste and integrate the plurality of multilayer substrates (10), wherein
before the step of stacking the insulating adhesive layer (40) on the upper surface of the one multilayer substrate (10),
the method comprises the step of filling a recess between the bonding land (34) and another metal layer or another bonding land (34) with insulating resin (42) on an upper surface of the one multilayer substrate (10) and a lower surface of the other multilayer substrate (10) and polishing a surface to flatten a surface opposed to the other multilayer substrate (10) so that there are no irregularities.
